(19) **Europäisches Patentamt** / **European Patent Office** / **Office européen des brevets**

(11) **EP 3 438 685 B1**

(12) **FASCICULE DE BREVET EUROPEEN**

| | |
|---|---|
| (45) Date de publication et mention de la délivrance du brevet: **16.03.2022 Bulletin 2022/11** | (51) Classification Internationale des Brevets (IPC): **G01R 31/392** *(2019.01)* |
| (21) Numéro de dépôt: **18166454.1** | (52) Classification Coopérative des Brevets (CPC): **G01R 31/392** |
| (22) Date de dépôt: **10.04.2018** | |

(54) **PROCÉDÉ D'ESTIMATION DE L'ÉTAT DE SANTÉ D'UNE SOURCE DE STOCKAGE D'ÉNERGIE ÉLECTRIQUE**

VERFAHREN ZUR VORHERSAGE DES GESUNDHEITSZUSTANDES EINER ELKTRISCHEN ENERGIEQUELLE

METHOD OF ESTIMATING THE STATE OF HEALTH OF AN ELECTRICAL POWER SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2017 FR 1757270**

(43) Date de publication de la demande:
**06.02.2019 Bulletin 2019/06**

(73) Titulaire: **SLAT**
**69410 Champagne au Mont d'Or (FR)**

(72) Inventeurs:
• **TOURNON, Edgar**
**69400 LIERGUES (FR)**
• **FUZIER, Laurent**
**38300 BOURGOIN JALLIEU (FR)**
• **BADOIL, Denis**
**69210 BULLY (FR)**

(74) Mandataire: **Cabinet Laurent & Charras**
**Le Contemporain**
**50 Chemin de la Bruyère**
**69574 Dardilly Cedex (FR)**

(56) Documents cités:
**US-A1- 2010 036 626    US-A1- 2010 052 617**
**US-A1- 2017 146 606**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### DOMAINE TECHNIQUE

La présente invention concerne le domaine de l'estimation de l'état de santé d'une source de stockage d'énergie électrique.

L'invention concerne plus particulièrement la détermination de l'état de santé d'une batterie de type Lithium Fer Phosphate, également connue sous l'abréviation LiFePO$_4$.

L'invention peut être appliquée dans de nombreux domaines techniques pour déterminer l'état de santé d'une source de stockage d'énergie électrique disposée dans un dispositif de sauvegarde d'énergie électrique.

Par exemple, l'invention trouve une application particulièrement avantageuse pour un commutateur réseau présentant des connecteurs intégrant un fil d'alimentation électrique. Cette technologie de commutateur réseau est appelée dans la littérature «POE» (selon l'expression anglo-saxonne «*Power Over Ethernet*»). Elle permet d'alimenter électriquement les appareils compatibles connectés sur le commutateur réseau en utilisant le câble internet pour transmettre l'alimentation électrique.

### ART ANTERIEUR

Une source de stockage d'énergie électrique est un dispositif électrochimique sujet au vieillissement. La température de fonctionnement, la température de stockage, le nombre de cycles utilisés et le courant de décharge sont autant de paramètres qui dégradent la durée de vie d'une source de stockage d'énergie électrique.

Pour connaître l'état de santé d'une source de stockage d'énergie électrique, il est connu de déterminer le rapport entre la capacité restante, noté Cr, de la source de stockage d'énergie électrique et sa capacité initiale, noté Ci.

L'état de santé est noté SOH dans la littérature (selon l'expression anglo-saxonne «*State of Health*») et il est exprimé en pourcentage.

Ainsi, l'état de santé est défini par la relation suivante :

SOH = Cr/Ci

La capacité initiale étant connue, il suffit de mesurer la capacité restante pour déterminer l'état de santé. De manière classique, lorsque l'état de santé est inférieur à un seuil compris entre 70 et 80%, la source de stockage d'énergie électrique est considérée comme obsolète. Ce seuil est fixé par le constructeur.

Lorsque la source de stockage d'énergie électrique est disposée dans un dispositif de sauvegarde d'énergie électrique, il est nécessaire de conserver de l'énergie dans la source de stockage d'énergie électrique, et il n'est pas possible de décharger complètement la source de stockage d'énergie électrique au risque qu'elle ne puisse plus assurer son rôle de protection en cas de coupure secteur. Ce faisant, il n'est pas possible de mesurer la capacité restante en déchargeant complètement la source de stockage d'énergie électrique.

Pour estimer la capacité restante sans décharger complètement la source de stockage d'énergie électrique, il existe plusieurs méthodes prédictives visant à estimer la capacité restante et/ou l'état de santé en fonction des conditions d'utilisation au cours du temps de la source de stockage d'énergie électrique.

Cette estimation en fonction des conditions d'utilisation présente des limites car deux sources de stockage d'énergie électrique identiques peuvent vieillir différemment, même lorsqu'elles sont soumises aux mêmes conditions d'utilisation. Cette différence peut s'expliquer par les tolérances de fabrication ou par les conditions de transport et de stockage. En effet, un stockage à une température supérieure à 50°C pendant plusieurs semaines a un impact non négligeable sur l'état de santé d'une source de stockage d'énergie électrique.

Cette différence de vieillissement entre deux sources identiques est également due à l'impossibilité de prendre en compte l'ensemble des paramètres correctement. En effet, la température, le nombre de cycle, l'âge, le courant de décharge et l'humidité sont des facteurs dégradant la batterie de manière unitaire mais également de manière couplée. L'ensemble de ces couplages est difficile à mesurer du fait du nombre de couplages et de situations importantes.

Pour résoudre ce problème, il est connu de réaliser une recherche expérimentale de l'état de santé d'une source de stockage d'énergie électrique.

Par exemple, le document US 6,789,026 ou le document US 2010/052617 décrit une méthode expérimentale consistant à mesurer la tension à vide à un premier instant, et à décharger la source de stockage d'énergie électrique d'une quantité d'énergie prédéterminée. La tension à vide est notée OCV dans la littérature (selon l'expression anglo-saxonne « *Open-Circuit Voltage* ») et permet d'estimer un état de charge, noté SOC dans la littérature (selon l'expression anglo-saxonne « *State Of Charge* »). En effet, chaque couple (SOC,OCV) est unique.

Suite à cette phase de décharge de la source de stockage d'énergie électrique, la tension à vide est à nouveau mesurée de telle sorte à déterminer la capacité restante en extrapolant la différence entre les états de charge par rapport à la quantité d'énergie déchargée. Par exemple, si le premier instant de mesure correspond à un état de charge de 80% de la charge complète et que le second point est obtenu après une décharge de 100mA/h à un état de charge de 60% de la charge complète, il est possible de déduire que 20% de la diminution de l'état de charge correspond à 100mA/h et que la capacité restante correspond à 500mA/h. Pour retrouver l'état de santé, il suffit de diviser la capacité restante par la capacité initiale. Par exemple, si la capacité initiale est de 550mA/h et que la capacité restante estimée est de 500mA/h, l'état de santé est supérieur à 90%.

Cette méthode expérimentale d'estimation est basée sur le fait que chaque tension à vide à un état de charge correspondant.

Cependant, les batteries de type Lithium Fer Phosphate présentent des plages de variation d'état de charge pour lesquelles la variation de tension à vide est très faible. Il s'ensuit que cette méthode décrite dans le document US 6,789,026 nécessite l'utilisation d'un circuit de mesure de la tension à vide particulièrement performant. Typiquement, ce circuit de mesure doit être capable de mesurer des variations inférieures au millivolt.

Le problème technique de l'invention consiste à estimer expérimentalement et plus simplement l'état de santé d'une source de stockage d'énergie électrique sans décharger complètement la source de stockage d'énergie électrique.

**EXPOSE DE L'INVENTION**

Pour résoudre ce problème technique, l'invention propose de décharger une source de stockage d'énergie électrique chargée d'une quantité d'énergie prédéterminée et de mesurer la tension à vide. Cette tension à vide est ensuite comparée à une valeur seuil pour estimer l'état de santé.

A cet effet, selon un premier aspect, l'invention concerne un procédé d'estimation de l'état de santé d'une source de stockage d'énergie électrique, ledit procédé comportant les étapes suivantes :

- décharge de ladite source de stockage d'énergie électrique d'une quantité d'énergie prédéterminée alors que ladite source est chargée ;
- mesure d'une tension à vide de ladite source de stockage d'énergie électrique ;
- comparaison entre ladite tension à vide et une valeur seuil définie en fonction d'un décrochement dans l'évolution de ladite tension à vide par rapport à un état de charge de ladite source de stockage d'énergie ; et
- estimation de l'état de santé en fonction de ladite comparaison.

Cette méthode expérimentale est issue de l'observation selon laquelle l'évolution de la tension à vide par rapport à l'état de charge présente un décrochement caractéristique compris entre 70% et 85% de l'état de charge. La position de ce décrochement par rapport à l'état de charge varie en fonction de l'état de santé de la source de stockage d'énergie électrique.

Par exemple, pour une batterie Lithium Fer Phosphate neuve, le décrochement apparait sensiblement à 71% de l'état de charge alors que, lorsque la batterie est obsolète, le décrochement apparait au-delà de 80% de l'état de charge. Lors de ces déplacements du décrochement, c'est-à-dire lors du vieillissement de la batterie, la tension de seuil caractéristique de ce décrochement ne varie pas.

Il est ainsi possible de déterminer si l'état de charge de la source de stockage d'énergie électrique est supérieur à ce décrochement caractéristique en mesurant simplement la tension à vide. En partant d'une source de stockage d'énergie électrique chargée et en déchargeant la source de stockage d'énergie électrique d'une quantité d'énergie prédéterminée, cette mesure de tension à vide peut être directement reliée à la capacité restante de la source de stockage d'énergie électrique et à l'état de santé.

Cette tension à vide présente une variation importante, de l'ordre de 40 mV par cellule, au niveau du décrochement. Comparativement au document US 6,789,026, il est donc possible de mesurer avec vingt fois moins de précision la tension à vide afin de visualiser ce seuil.

Selon un mode de réalisation, l'état de santé est estimé selon la condition suivante :

- si ladite tension à vide est supérieure à ladite valeur seuil, estimation que l'état de santé de la source de stockage d'énergie électrique est satisfaisant ; et
- si ladite tension à vide est inférieure à la valeur seuil, estimation que l'état de santé de la source de stockage d'énergie électrique est insatisfaisant.

Par exemple, en estimant l'état de santé d'une source de stockage d'énergie électrique dont la capacité initiale est de 1500 mA/h, la capacité restante doit être supérieure à 1200 mA/h pour que l'état de santé de la batterie soit satisfaisant, c'est-à-dire supérieur à 80% (car 1200 mA/h /1500 mA/h = 80%). Si le décrochement caractéristique apparait proche de 80% de l'état de charge, il suffit de décharger 20% de la capacité restante minimale acceptable, c'est-à-dire 240 mA/h (car 1200 mA/h * 0.2=240 mA/h).

Suite à cette décharge, si la tension à vide est supérieure à la valeur seuil, l'état de charge de la source de stockage d'énergie électrique est donc supérieur à 80%, la capacité restante est supérieure à 80% de la capacité initiale et l'état de santé est également supérieur à 80%. En revanche, si la tension à vide est inférieure à la valeur seuil, l'état de charge de la source de stockage d'énergie électrique est donc inférieur à 80%, la capacité restante est inférieure à 80% de la capacité initiale et l'état de santé est également inférieur à 80%.

Selon cet exemple, en déchargeant une seule fois 240 mA/h, soit 16% de la capacité initiale, il est possible d'estimer si la source de stockage d'énergie électrique présente un état de santé suffisant.

Ce mode de réalisation propose ainsi un procédé très simple permettant d'estimer expérimentalement et avec une grande précision l'état de santé d'une source de stockage d'énergie électrique sans décharger complètement la source de stockage d'énergie électrique.

Selon un mode de réalisation, ladite quantité d'énergie prédéterminée est obtenue en fonction d'un seuil limite d'état de santé pour lequel ladite source de stockage d'énergie électrique est considérée comme satisfaisante, selon la relation suivante :

$$Qe = A*SOHs$$

avec SOHs correspondant au seuil limite d'état de santé ; et A correspondant à une constante déterminée expérimentalement.

Ce mode de réalisation vise à déterminer la quantité d'énergie selon l'exemple précédemment exposé.

Selon un mode de réalisation, l'état de santé est estimé en effectuant plusieurs phases de :

- décharge de la source de stockage d'énergie électrique d'une quantité d'énergie prédéterminée alors que ladite source est chargée ; et
- mesure d'une tension à vide de ladite source de stockage d'énergie électrique.

Les deux phases sont réalisées avec des quantités d'énergie différentes de sorte à déterminer la quantité d'énergie pour laquelle ladite tension à vide correspond à ladite valeur seuil, l'état de santé étant obtenu en fonction de la quantité d'énergie déterminée.

Ce mode de réalisation vise à déterminer expérimentalement l'état de santé en détectant la quantité d'énergie nécessaire pour observer le décrochement caractéristique de l'évolution de la tension à vide par rapport à l'état de charge.

En reprenant l'exemple précédent, si la première quantité d'énergie de 240 mA/h permet d'estimer que la capacité restante est supérieure à 80% de la capacité initiale, c'est-à-dire que la tension à vide est supérieure à ladite valeur seuil, il faut décharger la source de stockage d'énergie électrique avec une quantité d'énergie plus importante pour observer le décrochement caractéristique.

Ainsi, dans une seconde phase, la source de stockage d'énergie électrique peut être déchargée d'une quantité d'énergie de 280 mA/h. Dans cette seconde phase, si la tension à vide est inférieure à la valeur seuil, la quantité d'énergie recherchée est comprise entre 240 mA/h et 280 mA/h.

Lorsque la quantité d'énergie est déterminée, par exemple en réalisant un nombre fini d'itérations, la capacité restante peut être déterminée. Pour une quantité d'énergie déterminée, il est possible d'obtenir directement l'état de santé car l'état de santé est lié linéairement à la quantité d'énergie déterminée.

Dans cet exemple, la recherche de la quantité d'énergie permettant d'observer le décrochement est limitée entre 15 et 30% de la capacité initiale car le décrochement caractéristique apparaît entre 70 et 85% de l'état de charge.

En variante, d'autres sources de stockage d'énergie électrique peuvent présenter un décrochement pour d'autres valeurs de l'état de charge.

Selon un mode de réalisation, lesdites étapes de décharge de la source de stockage d'énergie électrique et de mesure de ladite tension à vide sont réalisées après un temps de relaxation de ladite source de stockage d'énergie électrique pour lequel cette dernière n'est pas sollicitée ni chargée.

Ce temps de relaxation permet de mesure avec précision la tension à vide. De préférence, ledit temps de relaxation est supérieur à 1h30.

Selon un second aspect, l'invention concerne un commutateur réseau comportant :

- une entrée de tension alternative,
- une pluralité de connecteurs, au moins un connecteur intégrant un fil d'alimentation électrique non utilisé pour transmettre les données et isolé électriquement des autres fils du câble utilisés pour transmettre les données,
- un convertisseur de tension apte à transformer une tension alternative de l'entrée en une tension continue,
- une alimentation de secours comportant une source de stockage d'énergie électrique connectée à la tension continue et configurée pour alimenter le commutateur réseau lorsque l'entrée de tension alternative n'est pas alimentée, et
- un système de commande configuré pour mettre en oeuvre un procédé d'estimation de l'état de santé de ladite source de stockage d'énergie électrique selon le premier aspect de l'invention.

Ce second aspect de l'invention vise un commutateur réseau présentant des connecteurs intégrant un fil d'alimentation électrique. Cette technologie de commutateur réseau est appelée « POE » (selon l'expression anglo-saxonne « *Power Over Ethernet* ») dans la littérature.

Elle permet d'alimenter électriquement les appareils compatibles connectés sur le commutateur réseau en utilisant le câble internet pour transmettre l'alimentation électrique. Ce faisant, la source de stockage d'énergie électrique intégrée dans le commutateur réseau peut assurer le fonctionnement des appareils connectés en POE sur le commutateur réseau lors d'une coupure secteur.

Selon un mode de réalisation, ledit commutateur réseau comporte des moyens de déconnexion de ladite source de stockage d'énergie électrique de la tension continue commandés par ledit système de commande. Ces moyens de déconnexion permettent d'imposer un temps de relaxation à la source de stockage d'énergie électrique.

Selon un mode de réalisation, ledit commutateur réseau comporte un circuit de mesure de la tension à vide de ladite source de stockage d'énergie électrique connecté entre ladite source de stockage d'énergie électrique et la tension continue. Ce circuit de mesure peut être réalisé par le composant BQ 76920 de la société Texas Instrument®.

Selon un mode de réalisation, ledit commutateur réseau comporte des moyens de supervision de l'entrée de tension alternative, le système de gestion étant configuré pour détecter en temps réel une interruption de l'entrée de tension alternative de sorte à connecter ladite source de stockage d'énergie électrique lorsque ladite source de stockage d'énergie électrique est déconnectée de la tension continue.

Le procédé d'estimation de l'état de santé de l'invention est préférablement mis en oeuvre avec un temps de relaxation de la source de stockage d'énergie électrique. Ce faisant, durant ce temps de relaxation, la source de stockage d'énergie électrique est déconnectée et n'assure plus son rôle de source d'énergie de secours. Il est particulièrement avantageux de contrôler l'entrée de tension alternative pour reconnecter la source de stockage d'énergie électrique dès les premiers signes avantcoureur d'une coupure secteur, par exemple suite à une variation anormale de la tension secteur.

## DESCRIPTION SOMMAIRE DES FIGURES

La manière de réaliser l'invention ainsi que les avantages qui en découlent, ressortiront bien du mode de réalisation qui suit, donné à titre indicatif mais non limitatif, à l'appui des figures annexées dans lesquelles les figures 1 à 4 représentent :

- figure 1 : un organigramme d'un procédé d'estimation de l'état de santé d'une source de stockage d'énergie électrique selon un premier mode de réalisation de l'invention ;
- figure 2 : un organigramme d'un procédé d'estimation de l'état de santé d'une source de stockage d'énergie électrique selon un second mode de réalisation de l'invention ;
- figure 3 : une représentation de l'évolution de la tension à vide en fonction de l'état de charge d'une batterie de type Lithium Fer Phosphate ; et
- figure 4 : une représentation schématique d'un commutateur réseau selon un mode de réalisation de l'invention.

## DESCRIPTION DETAILLEE DE L'INVENTION

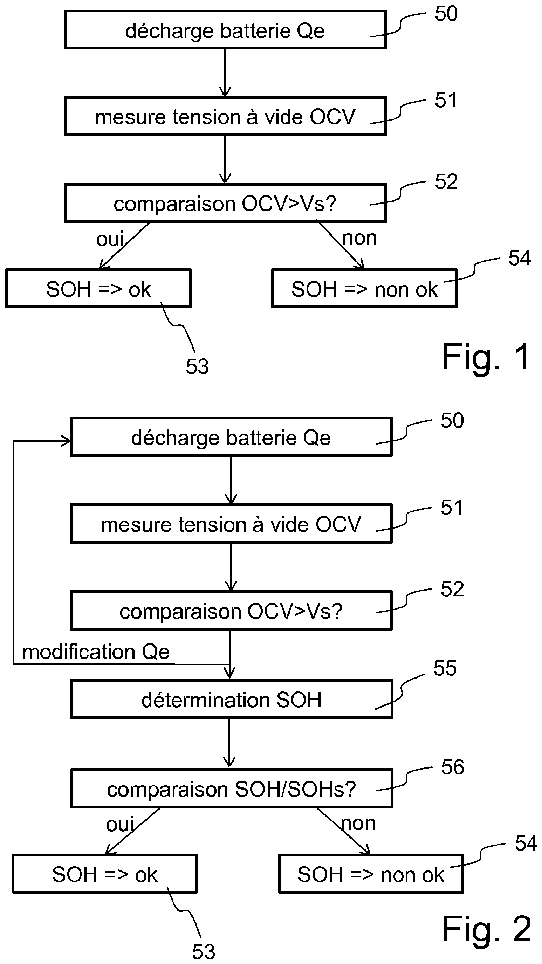

La figure 1 illustre un procédé d'estimation de l'état de santé **SOH** d'une source de stockage d'énergie électrique **23**. Une première étape **50** consiste à décharger la source **23** d'une quantité d'énergie prédéterminée **Qe** alors que la source **23** est complètement chargée.

Pour s'assurer que la source **23** est chargée, il suffit de brancher la source **23** sur une alimentation secteur pendant une durée suffisante qui dépend de la capacité initiale **Ci** de la source **23**, par exemple 3 heures. La quantité d'énergie **Qe** est ensuite déchargée sous la forme d'une demande ponctuelle, par exemple un créneau de courant sur une durée déterminée.

De préférence, la quantité d'énergie **Qe** est calculée selon la relation suivante :

Qe = A*SOHs

avec **SOCs** correspondant à un seuil d'état de charge et **SOHs** à un seuil limite d'état de santé ; et **A** correspondant à une constante déterminée expérimentalement.

Suite à cette consommation de la source **23**, la source **23** est préférentiellement déconnectée du circuit de charge pendant une durée de relaxation permettant à la source **23** de stabiliser sa tension à vide **OCV**. La durée de relaxation peut correspondre à une durée de 1h30 ou de 2h par exemple.

La tension à vide **OCV** est ensuite mesurée lors d'une seconde étape **51**. Cette tension à vide **OCV** peut être mesurée avec tous les circuits connus, par exemple le composant BQ 76920 de la société Texas Instrument®.

Une troisième étape **53** consiste à comparer cette tension à vide **OCV** avec une valeur seuil **Vs**. Si la tension à vide **OCV** est supérieure à la valeur seuil **Vs**, la source **23** est considérée comme présentant un état de santé satisfaisant **53**. A l'inverse, si la tension à vide **OCV** est inférieure à la valeur seuil Vs, la source **23** est considérée comme présentant un état de santé non satisfaisant **54**.

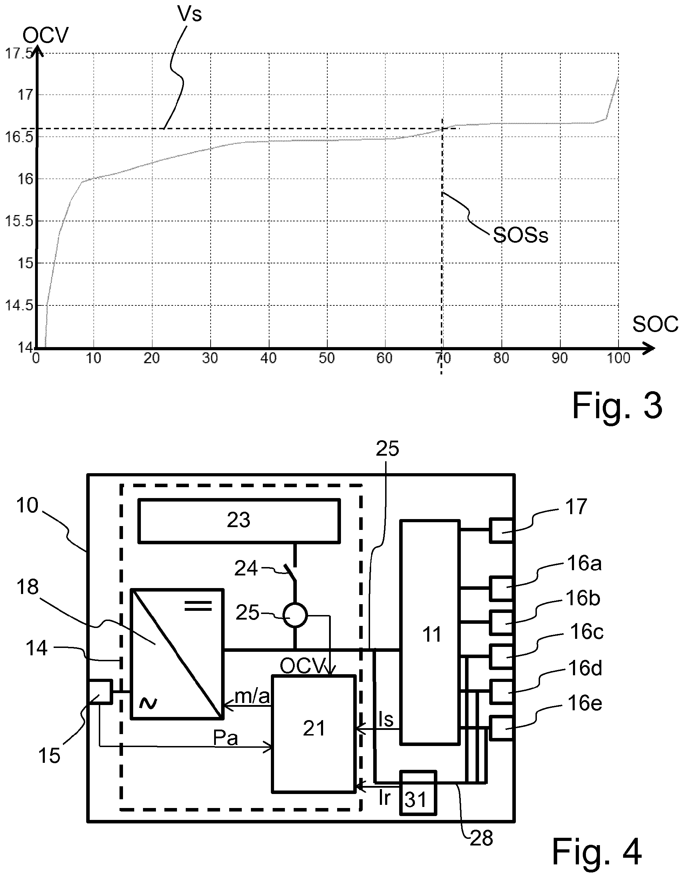

La simple comparaison de cette tension à vide **OCV** avec la valeur seuil **Vs** permet d'obtenir une information particulièrement pertinente en raison de l'évolution de la tension à vide **OCV** par rapport à l'état de charge **SOC**, illustrée sur la figure 3 pour une batterie Lithium Fer Phosphate.

La tension à vide **OCV** présente une phase de croissance rapide entre 0 et 8% de l'état de charge **SOC**, illustrant que, vers la fin de décharge d'une source **23**, la tension décroît rapidement. Entre 8 et 97% de l'état de charge **SOC**, la tension à vide **OCV** croit moins rapidement de 16 à 16.7 V. La croissance de la tension à vide **OCV** est particulièrement faible entre 72 et 97% de l'état de charge **SOC** puisque la tension à vide varie uniquement de 16,7 à 16.75 V.

Ce faisant, l'estimation de l'état de charge **SOC** par rapport à la mesure de la tension à vide **OCV** est particulièrement difficile sur cette période en raison de la faible variation de la tension à vide **OCV**. La tension à vide **OCV** présente une nouvelle phase de croissance rapide entre 97 et 100% de l'état de charge **SOC**.

Il existe un décrochement caractéristique de la tension à vide **OCV à** environ 70% de l'état de charge **SOC** puisque la tension à vide **OCV** varie de 16.5 V à 65% pour atteindre 16.7 V à 72%. La position de ce décrochement indique que la source **23** est sensiblement neuve.

En effet, pour une batterie Lithium Fer Phosphate neuve, le décrochement apparait sensiblement à 71% de l'état de charge **SOC** alors que, lorsque la batterie est obsolète, le décrochement apparait au-delà de 80% de l'état de charge **SOC**. Lors de ces déplacements du décrochement, c'est-à-dire lors du vieillissement de la batterie, la tension de seuil Vs caractéristique de ce décrochement ne varie pas.

Dans l'exemple de la figure 3, la tension à vide **OCV** est de 17.22 V à 100% de l'état de charge **SOC**, et la tension à vide **Vs** au niveau du décrochement **SOCs** est sensiblement de 16.52 V. Ainsi, si la tension à vide **OCV** est mesurée à 16.7 V, la source **23** peut être considérée comme satisfaisante, alors que si la tension à vide **OCV** est mesurée à 16.4 V, la source **23** peut être considérée comme insatisfaisante.

En variante, tel qu'illustré sur le procédé de la figure 2, le décrochement **SOCs** de la tension à vide **OCV** peut être recherché en faisant varier la quantité d'énergie **Qe** déchargée par la source **23** jusqu'à arriver à une quantité d'énergie **Qe** pour laquelle la tension à vide **OCV** mesurée correspond à la tension à vide **Vs** présente au niveau de ce décrochement caractéristique **SOCs**. La source **23** doit cependant être rechargée entre deux mesures de la tension à vide **OCV**.

Lorsque la quantité d'énergie **Qe** est déterminée par approximations successives, le procédé de la figure 3 propose de calculer l'état de santé **SOH** en fonction de la constante **A** par la relation suivante :
SOH = Qe/A

Cet état de sante SOH peut être comparé à un seuil d'état de santé SOHs, dans une étape **56**, pour déterminer si la source **23** est satisfaisante **53** ou insatisfaisante **54**.

L'invention permet donc d'estimer expérimentalement et de manière fiable l'état de santé **SOH** d'une source **23**. L'invention peut être appliquée à de nombreux domaines techniques.

La figure 4 illustre un mode de réalisation dans lequel l'invention est appliquée pour un commutateur réseau **10**.

Le commutateur réseau **10** comporte un connecteur amont **17**, une pluralité de connecteur avals **16a-16e,** et un organe de routage **11** configuré pour déterminer l'adresse physique de chaque connecteur **16a-16e, 17** et pour router les flux réseau entre les connecteurs **16a-16e, 17.**

L'organe de routage **11** est alimenté par une tension continue issue d'un convertisseur de tension **18** apte à transformer la tension alternative d'une entrée **15** en une tension continue **25**.

Une alimentation de secours **14** est également réalisée par le biais d'un élément de stockage d'énergie **23** connecté à la tension continue **25**, et configurée pour alimenter l'organe de routage **11** lorsque l'élément de stockage d'énergie **23** est chargé et que l'entrée **15** de tension alternative n'est pas alimentée. De préférence, l'élément de stockage d'énergie **23** est une batterie au Lithium Fer Phosphate, dont la capacité est comprise entre 5 Wh et 5 KWh.

Le commutateur réseau **10** comporte également un système de commande **21** configuré pour réaliser cette mesure de l'état de santé **SOH** de la source **23**. Pour ce faire, le système de commande **21** est relié à un circuit de mesure **26** permettant de mesurer la tension à vide **OCV**.

Pour décharger une quantité d'énergie **Qe** prédéterminée, le système de commande **21** peut superviser la consommation supportée par la tension continue **25**.

A cet effet, un dispositif de mesure **31** d'une consommation électrique **Ir** des périphériques **12b, 12c** connectés en POE est disposé dans le commutateur réseau **10** et transmet cette consommation électrique **Ir** au système de commande **21**. En variante, chaque connecteur aval **16a-16e** intégrant un fil d'alimentation électrique **28** peut comprendre son propre dispositif de mesure **31** de sorte à transmettre des mesures de consommation électrique **Ir** indépendantes pour chaque connecteur aval **16a-16e.**

En outre, la consommation **Is** de l'organe de routage **11** est également transmise au système de commande **21**.

Pour décharger la source **23**, le système de commande **21** interrompt le fonctionnement du convertisseur **18** par un signal de commande **m/a**. Le système de commande **21** analyse ensuite les consommations **Is** et **Ir** pour décharger la source **23** de la quantité d'énergie prédéterminée **Qe**. En variante, la source **23** peut être pourvue d'un capteur de courant pour obtenir la quantité d'énergie prédéterminée **Qe**.

Lorsque la quantité d'énergie **Qe** est atteinte, le système de commande **21** impose le fonctionnement du convertisseur **18** par le signal de commande **m/a** et déconnecte la source **23** par un interrupteur commandé **24** disposé entre la source **23** et la tension continue **25**.

Lorsque le temps de relaxation est écoulé, le système de commande **21** peut reconnecter la source **23** et mesurer la tension à vide **OCV** par le circuit **26** pour en déduire l'état de santé **SOH** selon l'un des procédé précédemment décrits.

Lors du temps de relaxation, le commutateur **10** est particulièrement vulnérable et le système de commande **21** supervise l'entrée **15** au moyen d'un signal **Pa** provenant de l'entrée **15**, de sorte à détecter rapidement une interruption de l'entrée **15** pour reconnecter la source **23**.

Le commutateur réseau **10** permet ainsi de garantir l'alimentation des périphériques connectés en POE tout en permettant d'estimer régulièrement l'état de santé de la source de stockage d'énergie électrique **23**. De préférence, cette estimation est réalisée une fois par mois dans une phase de faibles sollicitations, par exemple un dimanche et de nuit. Il s'ensuit qu'il est possible de détecter le besoin de remplacement de la source de stockage d'énergie électrique **23** pour anticiper une défaillance et améliorer l'estimation de la capacité restante **Cr**.

**Revendications**

1. Procédé d'estimation de l'état de santé (SOH) d'une source de stockage d'énergie électrique (23), ledit procédé comportant les étapes suivantes :

   - décharge (50) de ladite source de stockage d'énergie électrique (23) d'une quantité d'énergie prédéterminée (Qe) alors que ladite source (23) est chargée ; et
   - mesure (51) d'une tension à vide (OCV) de ladite source de stockage d'énergie électrique (10) ;

   *caractérisé* **en ce que** ledit procédé comporte également les étapes suivantes :

   - comparaison (52) entre ladite tension à vide (OCV) et une valeur seuil (Vs) définie en fonction d'un décrochement dans l'évolution de ladite tension à vide (OCV) par rapport à un état de charge (SOC) de ladite source de stockage d'énergie (23) ; et
   - estimation de l'état de santé (SOH) en fonction de ladite comparaison (52).

2. Procédé d'estimation de l'état de santé (SOH) d'une source de stockage d'énergie électrique (23) selon la revendication 1, dans lequel l'état de santé (SOH) est estimé selon la condition suivante :

   - si ladite tension à vide (OCV) est supérieure à ladite valeur seuil (Vs), estimation (53) que l'état de santé (SOH) de la source de stockage d'énergie électrique (23) est satisfaisant ; et
   - si ladite tension à vide (OCV) est inférieure à la valeur seuil (Vs), estimation (54) que l'état de santé (SOH) de la source de stockage d'énergie électrique (23) est insatisfaisant.

3. Procédé d'estimation de l'état de santé (SOH) d'une source de stockage d'énergie électrique (23) selon la revendication 2, dans lequel ladite quantité d'énergie prédéterminée (Qe) est obtenue en fonction d'un seuil limite d'état de santé (SOHs) pour lequel ladite source de stockage d'énergie électrique (23) est considérée comme satisfaisante, selon la relation suivante :
   Qe = A* SOHs
   avec SOHs correspondant au seuil limite d'état de santé ; et
   A correspondant à une constante déterminée expérimentalement.

4. Procédé d'estimation de l'état de santé (SOH) d'une source de stockage d'énergie électrique (23) selon la revendication 1, dans lequel l'état de santé (SOH) est estimé en effectuant plusieurs phases de :

   - décharge (50) de ladite source de stockage d'énergie électrique (23) d'une quantité d'énergie prédéterminée (Qe) alors que ladite source (23) est chargée ; et
   - mesure (51) d'une tension à vide (OCV) de ladite source de stockage d'énergie électrique (23) ;

   les deux phases étant réalisées avec des quantités d'énergie (Qe) différentes de sorte à déterminer la quantité d'énergie (Qe) pour laquelle ladite tension à vide (OCV) correspond à ladite valeur seuil (Vs) ; l'état de santé (SOH) étant obtenu (55) en fonction de la quantité d'énergie (Qe) déterminée.

5. Procédé d'estimation de l'état de santé (SOH) d'une source de stockage d'énergie électrique (23) selon l'une des revendications 1 à 4, dans lequel lesdites étapes de décharge (50) de la source de stockage d'énergie électrique (23) et de mesure (51) de ladite tension à vide (OCV) sont réalisées après un temps de relaxation de ladite source de stockage d'énergie électrique (23) pour lequel ladite source de stockage d'énergie électrique (23) n'est pas sollicitée ni chargée.

6. Procédé d'estimation selon la revendication 5, dans lequel ledit temps de relaxation est supérieur à 1h30.

7. Commutateur réseau (10) comprenant :

   - une entrée (15) de tension alternative,
   - une pluralité de connecteurs (16a-16e), au moins un connecteur (16a-16e) intégrant un fil d'alimentation électrique (28) non utilisé pour transmettre les données et isolé électriquement des autres fils du câble utilisés pour transmettre les données,
   - un convertisseur de tension (18) apte à transformer une tension alternative de l'entrée (15) en une tension continue (25), et
   - une alimentation de secours (14) comportant une source de stockage d'énergie électrique (23) connectée à la tension continue (25) et configurée pour alimenter le commutateur réseau (10) lorsque l'entrée (15) de tension alternative n'est pas alimentée,

   *caractérisé* **en ce que** le commutateur réseau (10) comporte en outre un système de commande (21) configuré pour mettre en oeuvre un procédé d'estimation de l'état de santé (SOH) de ladite source de stockage d'énergie électrique (23) selon l'une des revendications 1 à 6.

8. Commutateur réseau selon la revendication 7, dans lequel ledit commutateur réseau (10) comporte des moyens de déconnexion (24) de la source de stockage d'énergie électrique (23) de la tension continue (25) commandés par ledit système de commande (21).

9. Commutateur réseau selon la revendication 7 ou 8, dans lequel ledit commutateur réseau (10) comporte un circuit de mesure (26) de la tension à vide (OCV) de la source de stockage d'énergie électrique (23) connecté entre ladite source de stockage d'énergie électrique (23) et la tension continue (25).

10. Commutateur réseau selon l'une des revendications 7 à 9, dans lequel ledit commutateur réseau (10) comporte des moyens de supervision (Pa) de l'entrée (15) de tension alternative, le système de gestion (21) étant configuré pour détecter en temps réel une interruption de l'entrée (15) de tension alternative de sorte à connecter ladite source de stockage d'énergie électrique (23) lorsque ladite source de stockage d'énergie électrique (23) est déconnectée de la tension continue (25).

**Patentansprüche**

1. Verfahren zur Einschätzung des Gesundheitszustandes (SOH) einer elektrischen Energiespeicherquelle (21), wobei das Verfahren die folgenden Schritte umfasst

    - Entladen (50) dieser elektrischen Energiespeicherquelle (23) um eine vorher festgelegte Energiemenge (Qe), während diese Quelle (23) aufgeladen wird; und
    - Messung (51) einer Leerlaufspannung (OCV) dieser elektrischen Energiespeicherquelle (10):

    *dadurch gekennzeichnet, dass* dieses Verfahren auch die folgenden Schritte umfasst:

    - Vergleich (52) dieser Leerlaufspannung (OCV) mit einem Schwellenwert (Vs), definiert in Abhängigkeit von einem Kippen in der Entwicklung dieser Leerlaufspannung (OCV) bezogen auf einen Ladezustand (SOC) der erwähnten Energiespeicherquelle (23); und
    - Einschätzung des Gesundheitszustandes (SOH) in Abhängigkeit von diesem Vergleich (52).

2. Verfahren zur Einschätzung des Gesundheitszustandes (SOH) einer elektrischen Energiespeicherquelle (23) nach Anspruch 1, bei dem der Gesundheitszustand (SOH) nach der folgenden Bedingung eingeschätzt wird:

    - wenn die erwähnte Leerlaufspannung (OCV) über dem Schwellenwert liegt (Vs), Einschätzung (53), dass der Gesundheitszustand (SOH ) der elektrischen Energiespeicherquelle (23) zufriedenstellend ist, und
    - wenn diese Leerlaufspannung (OCV) unter dem Schwellenwert (Vs) liegt, Einschätzung (54), dass der Gesundheitszustand (SOH) der Energiespeicherquelle (23) nicht zufriedenstellend ist.

3. Verfahren zur Einschätzung des Gesundheitszustandes (SOH) einer elektrischen Energiespeicherquelle (23) nach Anspruch 2, bei dem die vorher bestimmte Energiemenge (Qe) erhalten wird in Abhängigkeit von einem Schwellenwert des Gesundheitszustandes (SOHs) für den diese elektrische Energiespeicherquelle (23) als zufriedenstellend angesehen wird nach der folgenden Gleichung:
Qe = A* SOHs
mit SOHs entsprechend dem Schwellenwert des Gesundheitszustandes; und
A entspricht dabei einer experimentell bestimmten Konstanten.

4. Verfahren zur Einschätzung des Gesundheitszustandes (SOH) eines elektrischen Energiespeicherquelle nach Anspruch 1, bei dem der Gesundheitszustand (SOH) durch Durchführung mehrerer Schritte:

    - Entladen (50) dieser elektrischen Energiespeicherquelle (23) um eine vorher festgelegte Energiemenge (Qe), während diese Quelle (23) aufgeladen wird; und
    - Messung (51) einer Leerlaufspannung (OCV) dieser elektrischen Energiespeicherquelle (23)

eingeschätzt wird, die beiden Phasen werden dabei mit unterschiedlichen Energiemengen (Qe) durchgeführt, um so die Energiemenge (Qe) zu bestimmen, bei der diese Leerlaufspannung (OCV) diesem Schwellenwert (Vs) entspricht.
der Gesundheitszustand (SOH) ergibt sich (55) dabei in Abhängigkeit von der bestimmten Energiemenge (Qe).

5. Verfahren zur Einschätzung des Gesundheitszustandes (SOH) einer elektrischen Energiespeicherquelle (23) nach einem der Ansprüche 1 bis 4, bei dem die erwähnten Schritte der Entladung (50) der elektrischen Energiespeicherquelle (23) und der Messung (51) der erwähnten Leerlaufspannung (OCV) nach einer Entspannungszeit dieser elektrischen Energiespeicherquelle (23) durchgeführt werden, während der diese elektrische Energiespeicherquelle (23) weder beansprucht noch geladen wird.

6. Einschätzungsverfahren nach Anspruch 5, bei dem diese Entspannungszeit länger als 1 h30 dauert.

7. Netzschalter (10) mit:

- einem Wechselspannungseingang (15),
- mehreren Steckverbindungen (16a-16e), mindestens ein Steckverbinder (16a- 16c) enthält dabei einen Stromversorgungsdraht (28), der nicht zur Datenübertragung verwendet wird und von den anderen Drähten des Kabels zur Datenübertragung elektrisch isoliert ist.
- einem Spannungswandler (18), der in der Lage ist, die Wechselspannung des Eingangs (15) in Gleichspannung zu wandeln, und
- einer Notversorgung (14), mit einer elektrischen Energiespeicherquelle (23) verbunden mit der Gleichspannung (25) und ausgelegt zur Versorgung des Netzschalters (10), wenn der Wechselspannungseingang (15) nicht versorgt wird. *dadurch gekennzeichnet, dass* der Netzschalter (10) außerdem ein Steuerungssystem (2l) enthält, das dazu ausgelegt ist, ein Einschätzungsverfahren des Gesundheitszustandes (SOH) der erwähnten elektrischen Energiespeicherquelle (23) nach einem der Ansprüche 1 bis 6 umzusetzen.

8. Netzschalter nach Anspruch 7, bei dem dieser Netzschalter (10) Mittel zum Lösen der Verbindung (24) zwischen der elektrischen Energiespeicherquelle (23) der Gleichspannung (25) enthält, die von diesem Steuersystem (21) gesteuert werden

9. Netzschalter nach Anspruch 7 oder 8, bei dem dieser Netzschalter (10) einen Messkreis (26) für die Leerlaufspannung (OCV) der elektrischen Energiespeicherquelle (23) enthält, angeschlossen zwischen der elektrischen Energiespeicherquelle (23) und der Gleichspannung (25).

10. Netzschalter nach einem der Ansprüche 7 bis 9, bei dem dieser Netzschalters (10) Vorrichtungen zur Überwachung (Pa) des Wechselspannungseingangs (15) enthält, das Managementsystem (21) ist dabei dazu ausgelegt, in Realzeit eine Unterbrechung des Wechselspannungseingangs zu erkennen, um so diese elektrischen Energiespeicherquelle (23) zu verbinden, wenn diese elektrische Energiespeicherquelle (23) von der Gleichspannung (25) getrennt wird.

**Claims**

1. Method of estimating the state of health (SOH) of an electrical power source (23), the said method comprising the following steps:

- discharging (50) of a predetermined quantity of electricity (Qe) from the electrical energy power source (23) while the said source is charged; and
- measurement (51) of an open-circuit voltage (OCV) of the said electrical power source (10) ;

*characterized in that* the said method also includes the following steps:

- comparison (52) between the said open-circuit voltage (OCV) and a threshold value (Vs) defined in accordance with a break in the development of the said open-circuit voltage (OCV) with respect to a state of charge (SOC) of the said electrical power source (23);
- and an estimation of the state of health (SOH) according to the said comparison (52).

2. Method of estimating the state of health (SOH) of an electrical power source (23) according to claim 1, in which the state of health (SOH) is estimated according to the following condition:

- if the said open-circuit voltage (OCV) is greater than the said threshold value (Vs), estimation (53) that the state of health (SOH) of the electrical power source (23) is satisfactory; and
- if the said open-circuit voltage (OCV) is less than the threshold value (Vs), estimation (54) that the state of health (SOH) of the electrical power source (23) is unsatisfactory.

3. Method of estimating the state of health (SOH) of an electrical power source (23) according to claim 2, in which the predetermined quantity of energy (Qe) is obtained according to a limit state of the state of health (SOHs) for which the said electrical power source (23) is considered to be satisfactory, according to the following relation:

$$Qe = A * SOHs$$

where SOHs corresponds to the limit threshold of the state of health; and
A corresponds to an experimentally determined constant.

4. Method of estimating the state of health (SOH) of an electrical power source (23) according to claim 1, in which the state of health (SOH) is estimated by carrying out several steps of:

- discharging (50) a predetermined amount of energy (Qe) from said electrical energy storage source (23) while said source (23) is charged; and

- measuring (51) an open circuit voltage (OCV) of said electrical energy storage source (23);

the two steps are carried out with different amounts of energy (Qe) in such a way as to determine the amount of energy (Qe) for which the said open-circuit voltage (OCV) corresponds to the said threshold value (Vs);
when the state of health (SOH) has been obtained (55) as a function of the determined amount of energy (Qe).

5. Method of estimating the state of health (SOH) of an electrical power source (23) according to one of claims 1 to 4, in which the discharge steps (50) of the electrical power source (23) and measurement (51) of the said open-circuit voltage (OCV) are carried out after a relaxation time of the said electrical power source (23) during which the electrical power source (23) in not solicited or charged.

6. Method of estimating according to claim 5, in which the said relaxation time is greater than 1h30min.

7. Network switch (10) comprising:

   - an AC voltage input (15),
   - a multitude of connectors (16a-16e), with at least one connector (16a-16e) including an electrical supply wire (28) not used for transmitting the data and that is electrically isolated from the other wires of the cable used for data transmission,
   - a voltage converter (18) capable of transforming an AC input voltage (15) into a DC voltage (25), and
   - a back-up power supply (14) comprising an electrical power source (23) connected to the Dc voltage (25) and set up to supply power to the network switch (10) when the AC voltage input (15) is not powered,

   *characterized in that* the network switch (10) also comprises a control system (21) configured to put into effect a method of estimating the state of health (SOH) of the said electrical power source (23) according to claims 1 to 6.

8. Network switch according to claim 7, in which the said network switch (10) comprises means of disconnection (24) of the electrical power source (23) of the DC voltage (25) controlled by the said control system (21).

9. Network switch according to claims 7 or 8, in which the said network switch (10) comprises a measurement circuit (26) of the open-circuit voltage (OCV) of the electrical power source (23) connected between the said electrical power source (23) and the DC voltage (25).

10. Network switch according to one of the claims 7 to 9, in which the said network switch (10) comprises supervision means (Pa) of the AC voltage input (15), while the management system (21) is set up to detect in real time an interruption of the AC voltage input (15) so as to connect the said electrical power source (23) when the said electrical power source (23) is disconnected from the DC voltage (25).

Fig. 1

Fig. 2

Fig. 3

Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6789026 B
- US 2010052617 A